# EUROPEAN PATENT SPECIFICATION

(11) **EP 4 149 103 B1**
(45) Date of publication and mention of the grant of the patent: **26.02.2025**
(21) Application number: 21195504.2
(22) Date of filing: 08.09.2021
(51) Int. Cl.: G02B 7/00, H01L 27/146, H04N 23/52, H04N 23/54

(54) **IMAGING APPARATUS WITH ATHERMAL MOUNTING**
BILDERZEUGUNGSGERÄT MIT ATHERMISCHER HALTERUNG
APPAREIL D'IMAGERIE À MONTAGE ATHERMIQUE

(43) Date of publication of application: 15.03.2023
(73) Proprietor: Robert Bosch GmbH, 70442 Stuttgart (DE)
(72) Inventor: BASTARDO, Pedro, 4410-515 São Félix da Marinha (PT); SPARIDAENS, Freek, 5613 EM Eindhoven (NL); ACAR, Yilmaz, 5629 PN Endhoven (NL)

(56) References cited:
- EP-A1- 3 061 384
- CN-A- 109 120 758
- US-A1- 2013 329 026
- US-A1- 2018 182 797

## Description

The invention concerns an imaging apparatus in accordance with claim 1.

Imaging apparatus are common in most industries around the world. Their application can range from traffic and weather monitoring systems to predictive and integrative approach to disease diagnosis. Traditional imaging apparatus comprise an imaging sensor that is mounted on a printed circuit board (PCB) to provide both, a necessary electrical connection and a mechanical support for the imaging sensor.

The document US 2013/0329026 A1 discloses an endoscope with an image mechanism, wherein lenses where held by a housing. On the lens, next to the imaging sensor, a glass is glued to the lens followed by the imaging sensor, a printed circuit board and cable. This part is put inside an outer cylinder. It has the advantage of its minimalized dimensions and easy aligning of the lenses.

The document EP 3061 384 A1 discloses an endoscope with an image capturing unit, wherein lenses where held by a housing. The housing also contains a flat glas, where a next glas is glued and followed by an image sensor with a printed circuit board connected to cable within an outer cylinder. It has the advantage of its minimalized dimensions.

The document CN 109120758 A discloses a smartphone or tablet computer with a camera and a light source as a time of flight measurement. The light source is arranged under a glas. The glas is glued to a bracket which have no lenses. In the bracket is a groove as a glue storage tank which is filled with glue. The adhesive prevent the glas from slipping or shaking relative to the bracket. So during the assembling, after the glue is in the storage tank, the glas is put on the brackets and the overflowing glue extent between the brackets and the glas.

The document EP 1 668 891 B1 proposes a camera arrangement for use in a motor vehicle, and a method for producing a camera arrangement. The camera arrangement comprises an imaging sensor, an optics unit, a housing and fastening means for fixing the imaging sensor relative to the housing, the housing having alignment means on the inside that enables the main axis of the imaging sensor and the main axis of the optics unit to be aligned axially with respect to one another.

### Disclosure of the invention

Subject-matter of the present invention is an imaging apparatus with the features of claim 1. Preferred and/or advantageous embodiments of the invention are disclosed by the subclaims, the following description and/or the figures as attached.

The invention relates to an imaging apparatus, in particular to a precision imaging system requiring sub-pixel stability. The imaging apparatus is configured to create visual representation of an indoor and/or exterior area. Preferably, the image apparatus is configured to photograph and/or to record an image or a series of images of a scene in the indoor and/or exterior area. The image apparatus is designed to photograph and/or to record a stationary and/or mobile item or a living object, e.g., a human being or a pet. Optional the image apparatus is configured to create visual representation of the interior of a human body for clinical analysis and medical intervention and/or visual representation of the function of some organs or tissues. Preferably, the imaging apparatus is used for one of the following: digital camera, camera modules, camera phones, optical devices, medical imaging equipment, night vision equipment such as thermal imaging devices.

The imaging apparatus comprises a housing, an imaging sensor and a carrier glass.

The housing is preferably configured to protect the imaging apparatus against mechanical damages, especially against the mechanical damages of inner workings of the imaging apparatus. The housing, in particular the casing provides for stability of the imaging apparatus. Preferably, the housing of the imaging apparatus is made of polymer and/or resin. Optionally, the housing of the imaging apparatus is made out of metal, a combination of metals and/or metals combined with one or more other elements. It is possible that the imaging apparatus comprises an optics, whereby the optics is arranged on and/or held by the housing.

The imaging sensor is designed as an electronic device. The imaging sensor is configured to detect and/or to convey information used to make an image. In particular, the imaging sensor is configured to convert a light received on the imaging apparatus or an imaging apparatus lens into a digital image. The imaging sensor is used in electronic imaging devices of both analog and digital types. The imaging sensor preferably comprises a sensor element. The sensor element may be realized as a CCD or CMOS or PSD element. It may be realized as a line sensor element or - preferred - as a matrix element.

The carrier glass is fixed to the housing and is configured to protect the inner workings of the imaging apparatus. In particular, the carrier glass provides a transparent protection to the inner working of the imaging apparatus. Preferably, the carrier glass is configured to let the light enter and/or reach the inner workings of the imaging apparatus, e.g., the imaging sensor. The carrier glass contains an outer lateral surface. Preferably, the carrier glass is made of a plain window or an optical filter glass.

According to the present invention, the imaging sensor is attached directly to the carrier glass. Especially the imaging sensor is held by the carrier glass and thus indirectly by the housing. The carrier glass is thus configured as a mechanical interface for the imaging sensor.

It is a finding of the invention, that deformation and displacement of imaging sensor in precision imaging systems especially requiring sub-pixel stability is functionally critical. The differences in material properties, such as for example coefficient of thermal expansion (CTE), between different parts of imaging apparatus, e.g., between a PCB and the imaging sensor may result in displacements and/or stresses within operational temperature range.

The invention is based on the object of eliminating stress and/or displacements on the imaging sensor relative to the housing. In particular, the stress and/or displacement that is caused by uneven thermal expansion of different materials. The present invention enables greater definition of structures and reduces noise to produce high quality images. Fixing the imaging sensor directly to the carrier glass and thus indirectly to the housing, results in an athermal mounting of the imaging sensor relative to the housing and reduces stress and/or displacements resulting from further components between the imaging sensor and the housing.

In a preferred embodiment of the invention the imaging sensor comprises an isolation glass. The isolation glass protects the sensor element of the imaging sensor. The isolation glass of the imaging sensor is bonded directly to the carrier glass, whereby the carrier glass is used as the mechanical interface for the imaging sensor. Preferably the imaging sensor is exclusively attached to the carrier glass through the isolation glass and/or the connection between the carrier glass and the isolation glass is the only connection of the imaging sensor to the carrier glass. Preferably, the isolation glass of the imaging sensor and the carrier glass consist of a similar and/or the same isotropic material. Alternatively, both the isolation glass of the imaging sensor and the carrier glass have a similar and/or the same coefficient of thermal expansion (CTE). Since both the sensor isolation glass and the carrier glass are made from same and/or similar isotropic materials, misalignment due to relative displacement and stresses based on temperature changes would not occur or be significantly reduced. Thus, this aspect's function is to eliminate stresses and/or displacements on image sensor caused by uneven thermal expansion of different materials used to construct an imaging sensor block. In particular, the isolation glass and the carrier glass are inseparably bonded over its entire surface. Especially the isolation glass and the carrier glass are cohesively bonded.

It is further preferred, that the isolation glass and the carrier glass are both round, especially circular. By using round especially circular shapes for the glasses, the thermal expansion in all radial directions is identical or at least similar. Preferably, the glasses are coaxially arranged for further enhancing the isotropic properties of the mounting of the imaging sensor.

Preferably, the imaging sensor, especially the isolation glass, is attached by an optical, especially optical clear adhesive to the carrier glass. The optical adhesive is configured to inseparable glue and/or bond both the imaging sensor, especially the isolation glass, and the carrier glass. The isolation glass is bonded to the carrier glass preferably over its entire surface by the optical adhesive. In particular, the optical adhesive consists of a transparent and/or translucent material. Preferably, the optical adhesive allows a light to pass through. In particular, the optical adhesive is configured to allow the objects to be captured by the imaging device and/or to be clearly seen through it.

According to the present invention, the carrier glass is attached to the housing by a mechanical adhesive. In particular, the carrier glass is inseparably attached to the housing of the imaging apparatus by the mechanical adhesive. Preferably, the mechanical adhesive comprises elastic properties. Optionally, the adhesive can change its volume due to a change of temperature. By attaching the carrier glass to the housing by the mechanical adhesive, mechanical stresses and/or tensions induced into the carrier glass can be reduced. Preferably, the mechanical adhesive is the mechanical interface, especially the only mechanical interface between the carrier glass and the housing, so that the carrier glass is adhesive-held and/or elastic-held.

Preferably, the mechanical adhesive is arranged at the outer lateral surface and/or outer circumference of the carrier glass. The mechanical adhesive is arranged in a circumferential direction of the carrier glass. In particular, the mechanical adhesive is applied peripheral between the housing of the imaging apparatus and the carrier glass. The mechanical adhesive is configured as an attachment between the carrier glass and the housing. In particular, the mechanical adhesive is configured to bridge an annular gap between the carrier glass and the housing. The advantage of this embodiment is that thermal expansions in radial direction are compensated in an isotropic manner by the mechanical adhesive.

The housing provides an expansion gap, whereby the expansion gap is realised as a further annular gap, whereby the expansion gap is positioned adjacent to the mechanical adhesive. The expansion gap has the same outer and inner diameter as the mechanical adhesive.

The expansion gap adjoins in the axial direction to the mechanical adhesive. The expansion gap provides expansion room for the mechanical adhesive, which can be used when the carrier glass is expanding in radial direction. It is further preferred that in one axial direction of the mechanical adhesive the expansion gap is positioned and in the other axial direction the mechanical adhesive can expand in a free area. In particular, the expansion gap is configured to receive the mechanical adhesive due to the size change of the carrier glass and/or the housing and/or the mechanical adhesive itself. With this embodiment tensions and stresses are reduced when the carrier glass expands due to the change of temperature in radial direction, because the mechanical adhesive can expand in both axial directions.

In one embodiment of the present invention, the imaging sensor comprises a sensor casing, whereby the sensor element is arranged in the sensor casing and whereby the sensor casing is sealed and/or protected by the isolation glass. Preferably, the sensor casing is made out of an isotropic and/or athermal material. In particular, properties of the casing's material are uniform in all directions. Alternatively, the properties of the material do not change with the temperature. In particular, the change in the material properties is not significant for the imaging sensor and/or imaging apparatus itself. The sensor casing is configured to protect the imaging sensor against impact and/or corrosion. Optionally, the sensor casing dissipates heat produced in the imaging apparatus. In some embodiment, the sensor casing is made of glass or ceramic. This configuration of the present invention is advantageous since it provides a predictable size variation of the casing resulting from a change of temperature.

In some embodiment of the present invention, the sensor casing has a coefficient of thermal expansion (CTE) smaller than 13^6 K^-1, in particular smaller than 10^6 K^-1 and especially smaller than 5^6 K^-1. In particular, the coefficient of thermal expansion of the sensor casing is not greater than 13^6 K^-1. This configuration of the invention is based on the idea of creating the sensor casing, whereby a material behavior of the sensor casing is highly predictable at different temperatures.

Preferably, the imaging apparatus comprises a carrying structure, whereby the carrying structure is mechanically coupled to the housing. In a preferred embodiment of the invention, the imaging sensor is mechanically decoupled from the carrying structure. In Particular, the carrying structure is configured as a structural element. The carrying structure is designed to carry the housing of the imaging apparatus. Optionally, the carrying structure is designed as a support for further inner workings of the imaging apparatus, whereby the inner workings are configured as a mechanism that functions internally to imaging apparatus and is not outwardly visible. Preferably, the carrying structure is composed of the same material as the housing of the imaging apparatus. For instance, the carrying structure is configured as a mounting interface of the imaging apparatus. By coupling the carrying structure to the housing and decoupling the carrying structure from the imaging sensor, the connection between the imaging sensor and the carrier glass is the only mechanical interface for carrying the imaging sensor. As this only mechanical interface of the imaging sensor is athermal, the imaging sensor is athermal mounted in the housing.

Preferably the imaging apparatus comprises a printed circuit board (PCB), wherein the imaging sensor is electrically connected to the PCB. In particular, the PCB is mechanically decoupled from the housing. The printed circuit board consists for example of a non-conductive substrate and at least one conductive track. The PCB may electrically connect the imaging sensor with further electrical or electronic components of the imaging apparatus using the conductive tracks, pads and/or other features etched from one or more sheet layers of copper laminated onto and/or between sheet layers of the non-conductive substrate. Particularly, the PCB consists of anisotropic material. Due to temperature changes relative to initial temperature, the anisotropic materials change their size and show different behavior in different directions. In particular, the printed circuit board is only used as a carrier and/or mechanical support for the imaging sensor, but is mechanically decoupled from the housing. The printed circuit board only serves as an interface for electrical connections, but is an open and/or unconnected end of the mechanical mounting of the imaging sensor.

It is especially preferred that the printed circuit board is mechanical decoupled from the carrying structure. The printed circuit board may be electrically connected by a cable or another connecting element to the carrying structure, which does not transfer mechanical movements, tensions, displacements or stresses.

Further features, advantages and effects of the invention are described in the following description of the figures and preferred embodiments of the invention. Similar or corresponding details in the figures are marked with the same reference numerals. The figures show:
Figure 1 a sectional view of an imaging apparatus as an embodiment of the invention;
Figure 2 a top view of the glass arrangement of the imaging apparatus from figure 1.

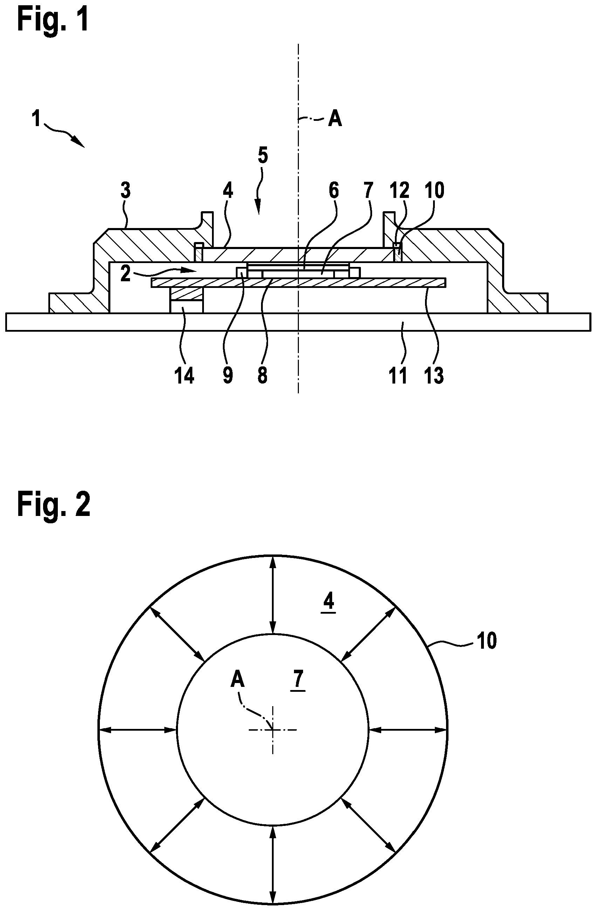

Figure 1 shows a schematic representation of an imaging apparatus 1 as an embodiment of the invention. The imaging apparatus 1 can be especially part of a camera for any application. Preferably, the imaging apparatus 1 is used in high quality applications, which need subpixel accuracy. The imaging apparatus 1 comprises an imaging sensor 2 for capturing images. The special construction of the imaging apparatus 1 allows to eliminate stresses and/or displacements on the imaging sensor 2 caused by uneven thermal expansion of different materials used to construct the imaging apparatus 1.

The imaging apparatus 1 comprises a housing 3, whereby the imaging sensor 2 is arranged in the housing 3. The housing 3 is placed on a carrying structure 11, which can be realised as a hard and especially athermal body. The imaging apparatus 1 comprises a carrier glass 4, whereby the carrier glass 4 is fixed to the housing 3. The housing 3 has an opening 5 for receiving optical signals of the object to be captured. The carrier glass 4 closes the opening 5 in order to protect the inner parts of the imaging apparatus 1 against external influences, for example dirt or mechanical impacts. Optionally an optics (not shown) is placed on the housing 3 in order to realise an optical imaging from the object onto the imaging sensor 2. The opening 5 is smaller in the dimensions than the carrier glass 4, whereby the carrier glass 4 is arranged in the inside of the housing 3 and may contact the housing 3 in axial direction from the inside.

The imaging sensor 2 is attached directly to the carrier glass 4. Especially the imaging sensor 2 contacts the carrier glass 4, whereby between the imaging sensor 2 and the carrier glass 4 optical adhesive 6 is arranged in order to connect the imaging sensor 2 and the carrier glass 4. The imaging sensor 2 is mechanically decoupled from the carrying structure 11, so that with this method, stresses originating from fixation of the imaging sensor 2 to the housing 3 are eliminated.

More precisely, the imaging sensor 2 comprises an isolation glass 7 and a sensor element 8, which is placed in optical direction under the isolation glass 7 in order to protect the sensor element 8. The imaging sensor 2 may further comprise a sensor casing 9, which houses the sensor element 8 and which is closed by the isolation glass 7. The sensor element 8 is for example a CCD- or CMOS- matrix-element. The sensor casing 9 may be made of ceramic or another athermal material. In order to minimise displacements, stresses and tensions resulting from temperature changes, only the isolation glass 7 is glued to the carrier glass 4 by the optical adhesive 6. The sensor casing 9 is not connected to the carrier glass 4, so that the contact area between imaging sensor and carrier glass 4 is realised as a glass-to-glass contact area.

Figure 2 shows a top view only of the glass section of the imaging apparatus 1. The carrier glass 4 as well as the isolation glass 7 are circular shaped and are arranged coaxial to an optical and/or mechanical axis A of the glasses 4, 7. The optical adhesive 6 is distributed over the complete contact area of the carrier glass 4 with the isolation glass 7. The optical adhesive 6 is optical clear in order to prevent a reduction of optical quality by the optical signals of the image passing the contact area of the glasses 4, 7.

In case temperature changes occur, the displacement of the imaging sensor 2 relative to the carrier glass 4 is minimised as all resulting stresses and tensions are symmetrically distributed around the optical and/or mechanical axis A of the glasses 4, 7. Consequently, the image position on the imaging sensor 2 and thus on the sensor element 8 is kept constant with respect to the radial direction to the optical and/or mechanical axis A of the glasses 4, 7. In other embodiments, the isolation glass 7 is rectangular. In this case, the circular shaped carrier glass 4 reduces at least the displacements in radial direction.

Returning to figure 1 it can be seen, that the carrier glass 4 is fixed to the housing 3 by our mechanical adhesive 10. The mechanical adhesive 10 is arranged in a circular ring (figure 2) between the carrier glass 4 and the housing 3. The mechanical adhesive 10 is arranged at the outer lateral surface and/or outer circumference of the carrier glass 4. In axial direction, no mechanical adhesive 10 is arranged between the carrier glass 4 and the housing 3. In case of temperature changes, the carrier glass 4 may expand in radical direction, which will be received and compensated by the mechanical adhesive 10, which is made from an elastic material. As the temperature expansion (or reduction) due to temperature changes is symmetrically distributed around the optical and/or mechanical axis A, no displacements, stresses and tensions are introduced into the carrier glass 4, so that using the mechanical adhesive 10 to fix the carrier glass 4 to the housing 3 further enhances the temperature stability of the optical apparatus 1 concerning the image position on the sensor element 8 with respect to the radial direction to the optical and/or mechanical axis A of the glasses 4, 7.

Additionally, an expansion gap 12 is formed into the housing 3, whereby the expansion gap 12 is arranged adjacent to the circular shaped mechanical adhesive 10. The expansion gap 12 allows an expansion of the mechanical adhesive 10 in axial direction in case the carrier glass 4 expands in radial direction with respect to the mechanical and/or optical axis A. In the other axial direction of the mechanical adhesive 10, there's free space, so that the mechanical adhesive 10 can expand freely in both axial direction. Consequently, the image position on the imaging sensor 2 and thus on the sensor element 8 is kept constant with respect to the radial direction to the optical and/or mechanical axis A of the glasses 4, 7.

The imaging apparatus 1 further comprises a printed circuit board 13, whereby the imaging sensor 2 is placed onto the printed circuit board 13. Especially, the imaging sensor 2 is mechanically coupled to the printed circuit board 13. Printed circuit boards in general are known as being anisotropic in view of temperature changes. In order to eliminate displacements, stresses and tensions resulting from the anisotropic behavior of the printed circuit board 13, the printed circuit board 13 is mechanically decoupled from the carrying structure 11 by a mechanical decoupling element 14. The mechanical decoupling element 14 can for example be realised as a loose cable, which is not able to transmit forces.

Other embodiments of the decoupling element 14 are possible, for example mechanical construction which allows a relative movement between the printed circuit board 13 and the carrier structure 11 while transferring electrical signals from the printed circuit board 13 to the carrying structure 11. Summarized, the printed circuit board 13 is mechanically connected to the imaging sensor 2 and is mechanically decoupled from the carrying structure 11 and thus from the housing 3. Consequently, displacements, stresses and tensions resulting from the movement of the printed circuit board 13 are not transferred to the housing 3 or influence the position of the imaging sensor 2 so that the sensor element 8 is kept constant with respect to the radial direction to the optical and/or mechanical axis A of the glasses 4, 7.

Deformation and displacement of imaging sensor in precision imaging systems requiring sub-pixel stability is functionally critical. Temperature changes due to environmental variations and/or operational thermal loads cause dimensional changes on materials. These dimensional changes are related to material properties and are different for different materials. When different materials come in contact with each other, mentioned thermal induced dimension changes may create stresses on parts resulting in deformations and/or displacements. Deformations may create distorted or unsharp images and displacements cause misalignment with optimum optical axis and sharpness gradient.

Imaging sensors are typically composed of a sensor element encased in a ceramic enclosure and covered by a transparent window typically made of glass. Sensors are soldered to printed circuit boards (PCB) to provide the necessary electrical connections which are needed to operate them. Most of the time PCB also serves as the mechanical mounting interface for imaging sensor.

The problem of dissimilar material properties becomes even more significant when material properties are not uniform within the part (i.e., anisotropic materials). Sensor casing materials, ceramic and glass are mostly isotropic and their behaviour at different temperatures are predictable but PCB materials, like FR4, show different behaviour in different directions, and if the orientation of material is not controlled, this results in unpredictable stress and displacement distributions.

Traditionally imaging sensors are mounted on printed circuit boards both to provide necessary electrical connections and to support the sensor mechanically. Differences in material properties between PCB and sensor housing may result in displacements and stresses within operational temperature range.

Imaging sensors normally contain a rectangular front glass to isolate sensor die from environment. If this front glass is bonded to a "carrier glass" using an optically clear adhesive, then this carrier glass can be used as the mechanical interface for sensor assembly. Here the carrier glass can be a plain window or an optical filter glass. Since both the sensor front glass and carrier glass are made from same/similar isotropic materials, misalignment due to relative displacement and stresses would not occur or be significantly reduced. In precision imaging systems, especially the ones requiring sub-pixel stability, supporting image sensor by a carrier glass having similar properties with sensor cover glass, provides better performance compared to conventional method of using sensor PCB as mechanical support.

## Claims

1. Imaging apparatus (1), comprising:
a housing (3),
a carrier glass (4), whereby the carrier glass (4) is fixed to the housing (3),
an imaging sensor (2),
the imaging sensor (2) is directly attached to the carrier glass (4)
wherein the carrier glass (4) is radially attached to the housing (3) by a mechanical adhesive (10)
**characterized by**
an expansion gap (12) in the housing (3) realized as an annular gap adjacent to the mechanical adhesive (10) in axial direction for providing expansion space for the mechanical adhesive (10).

2. Imaging apparatus (1) according to claim 1, **characterized in that** the imaging sensor (2) comprises an isolation glass (7), whereby the isolation glass (7) is attached directly to the carrier glass (4).

3. Imaging apparatus (1) according to claim 1, **characterized in that** the isolation glass (7) and/or the carrier glass (4) are round.

4. Imaging apparatus (1) according to one of the preceding claims, **characterized in that** the imaging sensor (2) is attached by an optical adhesive (6) to the carrier glass (4).

5. Imaging apparatus (1) according to one of the previous claims, **characterized in that** the mechanical adhesive (10) is arranged at the outer lateral surface and/or outer circumference of the carrier glass (4).

6. Imaging apparatus (1) according to one of the previous claims, **characterized in that** the imaging sensor (2) comprises a sensor casing (9), whereby the sensor casing (9) is made out of an isotropic and/or athermal material.

7. Imaging apparatus (1) according to one of the previous claims comprising a carrying structure (11), whereby the carrying structure (11) is mechanically coupled to the housing (3), whereby the imaging sensor (2) is mechanically decoupled from the carrying structure (11).

8. Imaging apparatus (1) according to one of the previous claims comprising a printed circuit board (13), wherein the imaging sensor (2) is electrically connected to the printed circuit board (13), whereby the printed circuit board (13) is mechanically decoupled from the housing (3).

9. Imaging apparatus (1) according to claim 8, whereby the printed circuit board (13) is mechanically decoupled from the carrying structure (11).

## Patentansprüche

1. Bilderzeugungsgerät (1), umfassend:
ein Gehäuse (3),
ein Trägerglas (4), wobei das Trägerglas (4) an dem Gehäuse (3) befestigt ist, einen Bildsensor (2),
wobei der Bildsensor (2) direkt am Trägerglas (4) befestigt ist,
wobei das Trägerglas (4) durch einen mechanischen Klebstoff (10) radial an dem Gehäuse (3) befestigt ist,
**gekennzeichnet durch**
einen Dehnungsspalt (12) in dem Gehäuse (3), der als Ringspalt benachbart zu dem mechanischen Klebstoff (10) in axialer Richtung ausgebildet ist, um Dehnungsraum für den mechanischen Klebstoff (10) bereitzustellen.

2. Bilderzeugungsgerät (1) nach Anspruch 1, **dadurch gekennzeichnet, dass** der Bildsensor (2) ein Isolierglas (7) umfasst, wobei das Isolierglas (7) direkt an dem Trägerglas (4) befestigt ist.

3. Bilderzeugungsgerät (1) nach Anspruch 1, **dadurch gekennzeichnet, dass** das Isolierglas (7) und/oder das Trägerglas (4) rund sind.

4. Bilderzeugungsgerät (1) nach einem der vorhergehenden Ansprüche, **dadurch gekennzeichnet, dass** der Bildsensor (2) durch einen optischen Klebstoff (6) an dem Trägerglas (4) befestigt ist.

5. Bilderzeugungsgerät (1) nach einem der vorhergehenden Ansprüche, **dadurch gekennzeichnet, dass** der mechanische Klebstoff (10) an der äußeren Seitenfläche und/oder dem äußeren Umfang des Trägerglases (4) angeordnet ist.

6. Bilderzeugungsgerät (1) nach einem der vorhergehenden Ansprüche, **dadurch gekennzeichnet, dass** der Bildsensor (2) ein Sensorgehäuse (9) umfasst, wobei das Sensorgehäuse (9) aus einem isotropen und/oder athermischen Material hergestellt ist.

7. Bilderzeugungsgerät (1) nach einem der vorhergehenden Ansprüche, umfassend eine Tragstruktur (11), wobei die Tragstruktur (11) mechanisch mit dem Gehäuse (3) gekoppelt ist, wobei der Bildsensor (2) mechanisch von der Tragstruktur (11) entkoppelt ist.

8. Bilderzeugungsgerät (1) nach einem der vorhergehenden Ansprüche, umfassend eine gedruckte Leiterplatte (13), wobei der Bildsensor (2) elektrisch mit der gedruckten Leiterplatte (13) verbunden ist, wobei die gedruckte Leiterplatte (13) mechanisch von dem Gehäuse (3) entkoppelt ist.

9. Bilderzeugungsgerät (1) nach Anspruch 8, wobei die gedruckte Leiterplatte (13) mechanisch von der Tragstruktur (11) entkoppelt ist.

## Revendications

1. Appareil d'imagerie (1), comprenant :
un boîtier (3),
un verre de support (4), le verre de support (4) étant fixé au boîtier (3), un capteur d'imagerie (2),
le capteur d'imagerie (2) étant directement fixé au verre de support (4) le verre de support (4) étant fixé radialement au boîtier (3) par un adhésif mécanique (10)
**caractérisé par**
un espace d'expansion (12) dans le boîtier (3) réalisé comme un espace annulaire adjacent à l'adhésif mécanique (10) dans la direction axiale pour fournir un espace d'expansion pour l'adhésif mécanique (10).

2. Appareil d'imagerie (1) selon la revendication 1, **caractérisé en ce que** le capteur d'imagerie (2) comprend un verre d'isolation (7), le verre d'isolation (7) étant fixé directement au verre de support (4).

3. Appareil d'imagerie (1) selon la revendication 1, **caractérisé en ce que** le verre d'isolation (7) et/ou le verre de support (4) sont ronds.

4. Appareil d'imagerie (1) selon l'une des revendications précédentes, **caractérisé en ce que** le capteur d'imagerie (2) est fixé par un adhésif optique (6) au verre de support (4).

5. Appareil d'imagerie (1) selon l'une des revendications précédentes, **caractérisé en ce que** l'adhésif mécanique (10) est agencé au niveau de la surface latérale extérieure et/ou de la circonférence extérieure du verre de support (4).

6. Appareil d'imagerie (1) selon l'une des revendications précédentes, **caractérisé en ce que** le capteur d'imagerie (2) comprend un boîtier de capteur (9), le boîtier de capteur (9) étant constitué d'un matériau isotrope et/ou athermique.

7. Appareil d'imagerie (1) selon l'une des revendications précédentes, comprenant une structure porteuse (11), la structure porteuse (11) étant couplée mécaniquement au boîtier (3), le capteur d'imagerie (2) étant découplé mécaniquement de la structure porteuse (11).

8. Appareil d'imagerie (1) selon l'une des revendications précédentes comprenant une carte de circuit imprimé (13), le capteur d'imagerie (2) étant connecté électriquement à la carte de circuit imprimé (13), la carte de circuit imprimé (13) étant mécaniquement découplée du boîtier (3).

9. Appareil d'imagerie (1) selon la revendication 8, la carte de circuit imprimé (13) étant mécaniquement découplée de la structure porteuse (11).
